# EUROPEAN PATENT APPLICATION

(11) **EP 2 911 183 A1**
(43) Date of publication of application: **26.08.2015**
(21) Application number: 13846328.6
(22) Date of filing: 12.09.2013
(51) Int. Cl.: H01L 21/02, C30B 29/06, C30B 31/22, C30B 33/02, H01L 21/265, H01L 21/324, H01L 27/12

(54) **SOI WAFER MANUFACTURING METHOD**

(30) Priority: 16.10.2012 JP 2012229111
(71) Applicant: Shin-Etsu Handotai Co., Ltd., Tokyo 100-0004 (JP)
(72) Inventor: QU, Wei Feng, Annaka-shi Gunma 379-0196 (JP); TAHARA, Fumio, Annaka-shi Gunma 379-0196 (JP); OOI, Yuuki, Annaka-shi Gunma 379-0196 (JP)
(74) Representative: Wibbelmann, Jobst
(86) International application number: PCT/JP2013/005396
(87) International publication number: WO 2014/061196

(57) **Abstract**

The present invention provides a method of manufacturing an SOI wafer, comprising, before forming an oxide film, heat treating a prepared silicon wafer at a temperature ranging from 1100°C to 1250°C under an oxidizing atmosphere for 30 minutes to 120 minutes and polishing a surface of the silicon wafer subjected to the heat treatment, which will become a bonding interface. The method can sufficiently dissolve defects in a bond wafer in SOI-wafer manufacture and manufacture an SOI wafer with few faults such as defects. The method also can repeatedly reuse a separated wafer, which is produced as a by-product in the ion implantation separation method, as the bond wafer.

## Description

### TECHNICAL FIELD

The present invention relates to a method of manufacturing a silicon-on-insulator (SOI) wafer by the so-called ion implantation separation method (also referred to as the Smart Cut method (registered trademark)), in which the SOI wafer is manufactured by separating an ion-implanted wafer after bonding.

### BACKGROUND ART

A representative method of manufacturing an SOI wafer is an ion implantation separation method.

The ion implantation separation method will now be briefly described. First, two silicon wafers are prepared as a bond wafer and a base wafer. An oxide film that will become a buried oxide film of an SOI wafer is formed on at least one of the wafers, for example the bond wafer. The silicon wafer on which the oxide film has been formed is then implanted with ions through the oxide film from its surface that will become a bonding interface, so that a layer of the implanted ions is formed in the silicon wafer. The silicon wafer in which the layer of the implanted ions has been formed is bonded to the base wafer. The silicon wafer is separated along the layer of the implanted ions into a separated wafer and an SOI wafer by a heat treatment. A bonding heat treatment is then performed to strengthen a bond as necessary. In this way, the SOI wafer is manufactured.

As device processes become finer, bond wafers for forming SOI layers of SOI wafers have been required to be free of defects. Currently, N-region (Nearly Perfect Crystal, NPC) wafers having few defects and a low oxygen concentration are used as the bond wafers for SOI (See

Patent Document 1).

Even when an NPC wafer free of crystal originated particle (COP) is thus used, however, a heat treatment for example at 900°C for 6 hours performed to form an oxide film that will become a buried oxide film of an SOI wafer may produce HF defects, which are defects related to oxide precipitation such as oxide precipitate nuclei and oxide precipitates (Bulk Micro Defect, BMD), in a surface layer that will become an SOI layer. Reuse of the separated wafer as the bond wafer makes the occurrence of the defects of this type particularly frequent.

In order to prevent the occurrence of such defects, a separated N-region wafer is conventionally subjected to a rapid thermal annealing (RTA) process to dissolve the defects in the surface layer before this wafer is reused as the bond wafer (See Patent Documents 2 to 4).

The RTA process, however, needs to be performed every time, thus creating the problem in that the repetition of the RTA process makes it easy to damage the bond wafer.

In order to reduce the number of heat treatment on the bond wafer in the regeneration process, the bond wafer may be heat treated under a non-oxidizing atmosphere or other atmosphere before an SOI wafer is manufactured (See Patent Document 5).

This method however needs a second heat treatment if an inspection before the reuse has revealed the presence of defects.

### CITATION LIST

### PATENT LITERATURE

Patent Document 1:Japanese Unexamined Patent publication (Kokai) No. 2006-294737
Patent Document 2:Japanese Unexamined Patent publication (Kokai) No. 2011-238758
Patent Document 3:Japanese Unexamined Patent publication (Kokai) No. 2008-021892
Patent Document 4:Japanese Unexamined Patent publication (Kokai) No. 2007-149907
Patent Document 5:Japanese Unexamined Patent publication (Kokai) No. 2011-176293

### SUMMARY OF INVENTION

### TECHNICAL PROBLEM

To solve these problems, the bond wafer to be used needs to have a BMD density, for example, less than 1×10⁷/cm³, which is detectable by laser scattering tomography (LST).

In addition, if the reuse of the bond wafer is considered to realize cost reduction of an SOI wafer, then it is necessary to develop wafer manufacturing techniques that provide a wafer completely free of defects up to the wafer bulk.

The present invention was accomplished in view of the above-described problems. It is an object of the present invention to provide an SOI-wafer manufacturing method that can sufficiently dissolve defects in a bond wafer in SOI-wafer manufacture and manufacture an SOI wafer with few faults such as defects. It is another object of the present invention to provide an SOI-wafer manufacturing method that can repeatedly reuse as the bond wafer a separated wafer, which is produced as a by-product in the ion implantation separation method.

### SOLUTION TO PROBLEM

To achieve this object, the present invention provides a method of manufacturing an SOI wafer, comprising the steps of: preparing a silicon wafer as a bond wafer, the silicon wafer being sliced from a silicon single crystal ingot grown by a Czochralski method; heat treating the prepared silicon wafer at a temperature ranging from 1100°C to 1250°C under an oxidizing atmosphere for 30 minutes to 120 minutes; polishing a surface of the silicon wafer subjected to the heat treatment, the surface becoming a bonding interface; forming an oxide film on the prepared silicon wafer after the heat treating step; implanting ions into the silicon wafer on which the oxide film has been formed so as to form a layer of the implanted ions in the silicon wafer, the ions being implanted from the surface of the silicon wafer through the oxide film; and bonding a base wafer to the silicon wafer in which the layer of the implanted ions has been formed and separating the silicon wafer along the layer of the implanted ions into a separated wafer and the SOI wafer.

The inventive method of manufacturing an SOI wafer thus performed can sufficiently dissolve defects in the bond wafer in SOI-wafer manufacture and manufacture an SOI wafer with few faults such as defects. The method also can repeatedly reuse as the bond wafer the separated wafer, which is produced as a by-product in the ion implantation separation method.

In the polishing step, after an oxide film formed on the silicon wafer by the heat treatment is removed, the surface is preferably polished by 0.1 µm to 0.2 µm.

In this manner, the polishing of the surface by 0.1 µm to 0.2 µm after removing the oxide film enables defects produced right under an oxide film formed by the heat treatment under an oxidizing atmosphere to be reliably removed.

Moreover, the separated wafer is preferably to be reused as the bond wafer when an SOI wafer is manufactured.

In the inventive method, the heat treatment under an oxidizing atmosphere and the surface polishing sufficiently dissolve defects in the separated wafer produced as a by-product; thereby the reuse of the separated wafer as the bond wafer enables a high quality SOI wafer to be manufactured with high productivity at low cost.

Moreover, an N-region (Nearly Perfect Crystal) wafer having an initial oxygen concentration of 14 ppma or less, or a nitrogen-doped wafer having an initial oxygen concentration of 7 ppma or less is preferably prepared as the silicon wafer.

Use of the wafer of this type practically prevents the formation of HF defects, even when the heat treatment for forming the oxide film that will become a buried oxide film of the SOI wafer, i.e., oxidation heat treatment, is repeatedly performed in manufacture of SOI wafers.

Moreover, the nitrogen-doped wafer preferably has a nitrogen concentration of 1×10¹³ to 1×10¹⁵ atoms/cm³.

When the nitrogen-doped wafer having the above nitrogen concentration is used, the heat treatment under an oxidizing atmosphere and the surface polishing in the invention enable oxide precipitate nuclei, oxide precipitates and the like, which cause HF defects, to be completely dissolved from a portion up to the wafer bulk.

### ADVANTAGEOUS EFFECTS OF INVENTION

As described above, the present invention can sufficiently dissolve oxide-precipitation-related defects of a bond wafer, thereby enabling the inhibition of the occurrence of HF defects; since the bond wafer can prevent HF defects from occurring and growing therein even when a heat treatment is performed to form an oxide film that will become a buried oxide film of an SOI wafer during an SOI-wafer manufacturing process, a high quality SOI wafer having excellent electrical properties and an SOI layer with few faults such as defects can be efficiently manufactured. In addition, the invention is economic because a separated wafer, which is produced as a by-product by the ion implantation separation method, can be repeatedly reused as the bond wafer and the cost can thereby be reduced.

### BRIEF DESCRIPTION OF DRAWINGS

FIG. 1 is a flowchart of an exemplary embodiment of the inventive method of manufacturing an SOI wafer;
FIG. 2 is a graph of HF defect densities by the number of reuse in example 1 and comparative examples 1 to 3; and
FIG. 3 is a graph of a HF defect density in example 2.

### DESCRIPTION OF EMBODIMENTS

Hereinafter, the present invention will be described in more detail.

As described previously, during manufacture of an SOI wafer, HF defects due to an oxidization heat treatment in a manufacturing process of the SOI wafer may conventionally be detected at its center portion. In addition, reuse of a separated wafer as a bond wafer requires a heat treatment every time or at least when the defects are detected, in order to dissolve the defects in a surface layer.

In view of this, the present inventors considered conditions under which an SOI wafer with few faults such as HF defects can be manufactured by reusing the separated wafer, which is produced as a by-product by the ion implantation separation method, as the bond wafer even when the separated wafer has not been frequently subjected to a heat treatment to dissolve crystal defects in the surface layer of the separated wafer. 'HF defect' is a general term for a crystal defect in an SOI layer, which is detectable by immersing an SOI wafer in a HF solution and finding a hollow produced when the HF solution passes through a defect portion penetrating the SOI layer and etches a buried oxide layer.

The inventors consequently found that a silicon wafer prepared as the bond wafer is subjected to a heat treatment at a temperature ranging from 1100°C to 1250°C under an oxidizing atmosphere for 30 minutes to 120 minutes as a pretreatment before an oxide film for a buried oxide film is formed and subsequent surface polishing; this heat treatment (also referred to as "the inventive heat treatment" below for convenience) first performed once prevents the formation of HF defects even when the oxidization heat treatment in SOI-wafer manufacture is repeated. The inventors thereby brought the present invention to completion.

An embodiment of the present invention will now be described in detail by way of example with reference to figures, but the present invention is not limited to this embodiment.

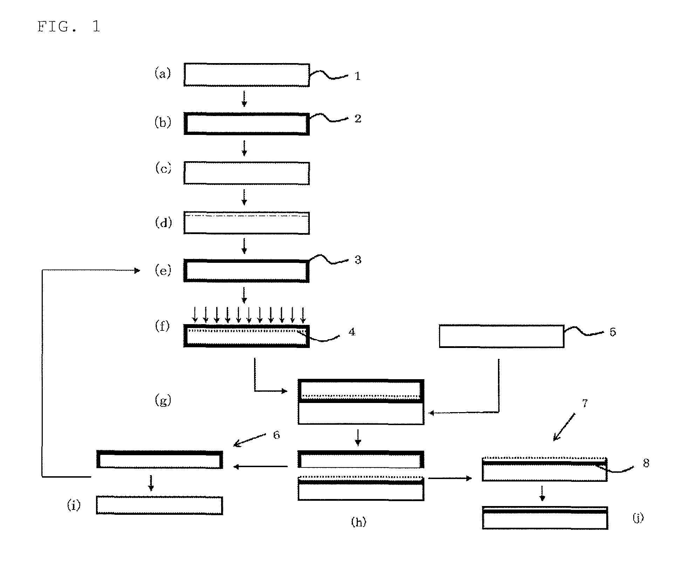

FIG. 1 is a flowchart of an exemplary embodiment of the inventive method of manufacturing an SOI wafer.

The inventive manufacturing method begins with the preparation of a silicon wafer to be used as a bond wafer 1 by slicing a silicon single crystal ingot grown by the Czochralski method (FIG. 1 at (a)).

The prepared silicon wafer, bond wafer 1, may be, for example, a silicon wafer whose at least one surface is mirror-polished. The present invention particularly preferably uses an N-region (NPC) wafer having an initial oxygen concentration of 14 ppma or less, or a nitrogen-doped wafer having an initial oxygen concentration of 7 ppma or less; these values use a conversion factor according to Japan Electronics Industry Development Association (JEIDA) and JEIDA changed its name to Japan Electronics and Information Technology Industries Association (JEITA).

The oxidization heat treatment repeatedly performed in SOI-wafer manufacture hardly forms HF defects in an N-region (NPC) and a nitrogen-doped wafer that have been first subjected to the inventive heat treatment, if the N-region wafer thus has an initial oxygen concentration of 14 ppma or less (JEIDA), and the nitrogen-doped wafer thus has an initial oxygen concentration of 7 ppma or less (JEIDA) if not an N-region.

In particular, a nitrogen-doped wafer having a low oxygen concentration makes the defect size small and enables oxide precipitate nuclei, oxide precipitates, and the like that cause HF defects to be completely dissolved up to its bulk by the inventive heat treatment, although this wafer is not an N-region wafer.

When a nitrogen-doped wafer is used, the nitrogen-doped wafer preferably has a nitrogen concentration of 1×10¹³ to 1×10¹⁵ atoms/cm³.

A heat treatment is then performed on the prepared silicon wafer at a temperature ranging from 1100°C to 1250°C under an oxidizing atmosphere for 30 minutes to 120 minutes (FIG. 1 at (b)).

The oxidizing atmosphere may be an oxygen atmosphere or a mixed gas of an oxygen gas and a rare gas etc. The mixed gas contains an oxygen gas with a content more than 50%. The atmosphere under which the heat treatment is performed may be selected properly according to the properties of the bond wafer to be used; the oxygen atmosphere (100% oxygen gas) is particularly preferable because defects can be efficiently dissolved.

This heat treatment can be performed with, for example, a resistance-heating heat-treating furnace.

The heat treatment temperature is in the range from 1100°C to 1250°C. The heat treatment time is in the range from 30 minutes to 120 minutes.

The heat treatment thus performed at a high temperature of 1100°C or more for 30 minutes or more can completely dissolve oxide precipitate nuclei, oxide precipitates, and the like in the bulk at one time and eliminate the need for performing the heat treatment every time to dissolve defects in the surface layer in the later step of reusing the separated wafer as the bond wafer, thereby enabling the simplification of the processes.

The heat treatment at a temperature more than 1250°C, however, is hard on the bond wafer, resulting in problems of the occurrence of slip dislocation and impurity contamination. The heat treatment is accordingly performed at a temperature of 1250°C or less; from the viewpoint of the effect and efficiency of the heat treatment, the heat treatment is performed for 120 minutes or less, because this heat treatment performed for about 120 minutes can also dissolve the defects in the bulk.

The temperature is preferably in the range from 1170°C to 1200°C and the time is preferably in the range from 60 minutes to 120 minutes.

The heat treatment thus performed at a temperature ranging from 1100°C to 1250°C under an oxidizing atmosphere for 30 minutes to 120 minutes is effective to reduce the oxide precipitate nuclei, oxide precipitates and the like, which cause HF defects, because the heat treatment injects interstitial silicon to pair annihilate vacancies in the bulk.

The heat treatment thus performed under an oxidizing atmosphere dissolves bulk precipitates due to oxidation, but tends to grow crystal defects due to inward diffusion of oxygen at the vicinity of the surface layer, whose thickness depends on the heat treatment temperature and oxygen solid solubility of a substrate, right below an oxide film, so that the defects clearly appears. In this growth, an oxide film on the inner surface of COPs thickens, an oxide film is formed on the inner surface of vacancies, and BMD grows. It is accordingly necessary to perform a step of polishing a surface of the silicon wafer that will become the bonding interface after the heat treatment (FIG. 1 at (d)).

The polishing stock removal of this surface can be appropriately determined: it is typically sufficient to polish by about 0.2 µm from the surface; the polishing stock removal is more preferably in the range from 0.1 µm to 0.2 µm.

As shown in FIG. 1 at (b), the inventive heat treatment may form an oxide film 2 in some cases. In these cases, the polishing in FIG. 1 at (d) may be performed after removing the oxide film 2 (FIG. 1 at (c)).

The oxide film 2 can be removed by etching or otherwise. In the above polishing step, the bonding interface of the silicon wafer (bond wafer 1) may be polished successively after the oxide film is previously removed.

The oxide film 3 that will become the buried oxide film 8 of the SOI wafer is then formed on the silicon wafer (bond wafer 1) (FIG. 1 at (e)). The oxide film 3 can be formed by, for example, a heat treatment at a temperature ranging from about 900°C to 1200°C for 5 to 6 hours. In FIG. 1 at (e), the oxide film 3 is formed on the entire surface of the silicon wafer (bond wafer 1), but may be formed only on the bonding interface.

The silicon wafer on which the oxide film 3 has been formed is then implanted with ions from the surface that will become the bonding interface through the oxide film 3, so that a layer 4 of the implanted ions is formed in the silicon wafer (FIG. 1 at (f)).

The depth of this layer 4 depends on the ion-implantation energy. A larger ion-implantation-energy is accordingly needed to implant ions deeply. In typical cases, the ions are implanted to a depth of about 2 µm from the surface of the oxide film 3 at the most and often to a depth equal to or less than 1 µm.

The silicon wafer (bond wafer 1) into which the layer 4 of the implanted ions has been formed is then bonded to a base wafer 5 such that the surface on the side of the layer 4 is bonded with the oxide film 3 interposed therebetween (FIG. 1 at (g)). The base wafer 5 may be for example, but not particularly limited to, a silicon wafer. After the bonding, a separation heat treatment is performed to separate the silicon wafer (bond wafer 1) along the layer 4 of the implanted ions into a separated wafer 6 and the SOI wafer 7 (FIG. 1 at (h)). Alternatively, before the bond wafer 1 and the base wafer 5 are bonded together, either or both of the wafers may be subjected to a plasma treatment on the bonding interface to enhance the bonding strength, so that the separation heat treatment can be eliminated and the silicon wafer can be mechanically separated instead.

A bonding heat treatment to enhance the bonding strength may be performed, or the surface of the SOI wafer 7 after the separation may be polished, as necessary. In this way, an SOI wafer having a defect-free SOI layer can be obtained (FIG. 1 at (j)).

The separated wafer 6 thus produced as a by-product in the inventive manufacturing method is preferably reused as a bond wafer in manufacture of another SOI wafer.

As described previously, the bond wafer subjected to the inventive heat treatment and surface polishing has hardly any oxide precipitate nuclei, oxide precipitates, and the like. More specifically, even a separated wafer from which an SOI layer having about 1 µm thickness is separated has hardly any oxide precipitate nuclei, oxide precipitates, and the like. The separated wafer 6 can therefore be reused as a bond wafer merely by being polished by a small polishing stock removal (FIG. 1 at (i)). The SOI wafer can thus be manufactured with high productivity at low cost.

The polishing stock removal when the separated surface is polished may be, but not particularly limited to, 3 µm or more, preferably more than 5 µm, in order to reliably remove a step formed at a peripheral portion on the separated surface and the strain of the ion-implanted layer and sufficiently inhibit the occurrence of bonding failure.

The separated wafer 6 whose separated surface has been polished in the above manner as a regeneration process will be used as a bond wafer when the steps shown in FIG.1 at (e) to (g) are performed again. The present invention can thus manufacture an SOI wafer free of HF defects by reusing the separated wafer 6 as a bond wafer, even when the separated wafer is not again subjected to the heat treatment step (b). In addition, the separated wafer after the manufacture of this SOI wafer can be reused many times, for example, by performing the above regeneration process (polishing) again. This enables a high quality SOI wafer to be manufactured at low cost.

### EXAMPLE

The present invention will be more specifically described below with reference to examples and comparative examples, but the present invention is not limited to these examples.

### (Example 1 and Comparative Examples 1 to 3)

### Evidence of Effect of Resistance Heating Treatment

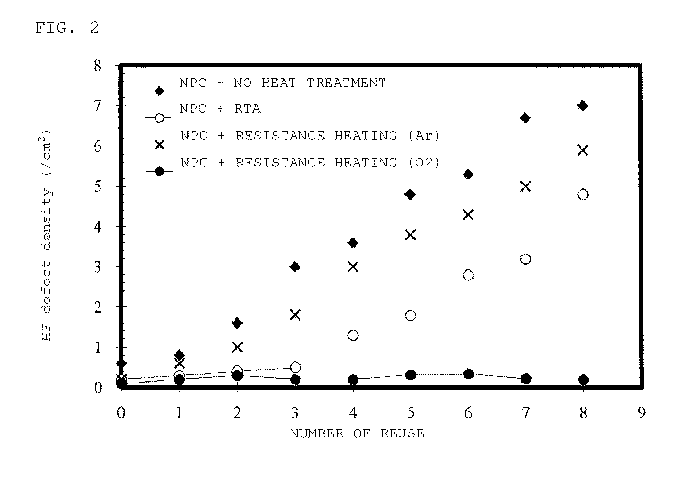

An N-region (NPC) silicon wafer having a diameter of 200 mm and an initial oxygen concentration of 12 ppma was subjected to (condition 1) no pretreatment, (condition 2) RTA, (condition 3) a resistance heating treatment, or (condition 4) a resistance heating treatment and polishing. A bond-wafer pseudo-reusing process was then repeated to compare the HF defect density by the number of reuse by the successive steps of: (1) an oxidation heat treatment at 900°C for 6 hours; (2) removal of an oxide film with HF (pseudo-separation); (3) measurement of the density of HF defects having a size of 65 nm or more with SP1 made by KLA-Tencor Corp.; (4) 5µm polishing (the number of reuse at this point was zero); and repetition of the processes (1) to (4). The result is shown in FIG. 2.

The pseudo-separation in (2) corresponded to a step into which the separation step (the bonding with the base wafer and the separation along the layer of the implanted ions) in an actual manufacture process of an SOI wafer was replaced, and this step is to remove the oxide film with HF after the oxidation heat treatment in (1). It is known that the result of the evaluation with this replacement demonstrates the same tendency as in measurement of the HF defect density of an actual SOI wafer.

### (Comparative Example 1)

Condition 1: NPC + no heat treatment

### (Comparative Example 2)

Condition 2: NPC + RTA (an argon atmosphere, a heating rate of 50°C/second, a maximum temperature of 1250°C, a retention time of 10 seconds)

### (Comparative Example 3)

Condition 3: NPC + resistance heating (an argon atmosphere, 1200°C, 60 minutes)

### (Example 1)

Condition 4: NPC + resistance heating (an oxygen atmosphere, 1200°C, 60 minutes) + 0.1 µm surface polishing

As shown in FIG. 2, comparative example 1 (condition 1 of 'NPC + no heat treatment'), in which no heat treatment as a pretreatment was performed, demonstrated that HF defects were detected in and after the zeroth reuse; the HF defect density increased with an increase in the number of reuse, although the density was at an acceptable level until the second reuse. Comparative example 2 (condition 2 of 'NPC + RTA'), in which RTA was performed as a pretreatment, demonstrated that HF defects were detected in and after the fourth reuse; the HF defect density increased with an increase in the number of reuse, although the density was at an acceptable level until the fifth reuse. Comparative example 3 (condition 3 of 'NPC + resistance heating'), in which a heat treatment under an argon atmosphere was performed as a pretreatment, demonstrated that HF defects were detected in and after the first reuse; the HF defect density increased with an increase in the number of reuse, although the density was at an acceptable level until the third reuse.

In contrast, example 1 (condition 4 of 'NPC + resistance heating'), in which a heat treatment under an oxygen atmosphere and 0.1 µm surface polishing were performed as a pretreatment, demonstrated that HF defects were hardly detected even when the number of reuse increased and the density was kept low.

### (Example 2)

### Evaluation of Effect Depending on Difference in Initial Oxygen Concentration of Nitrogen-doped Wafer and NPC Wafer

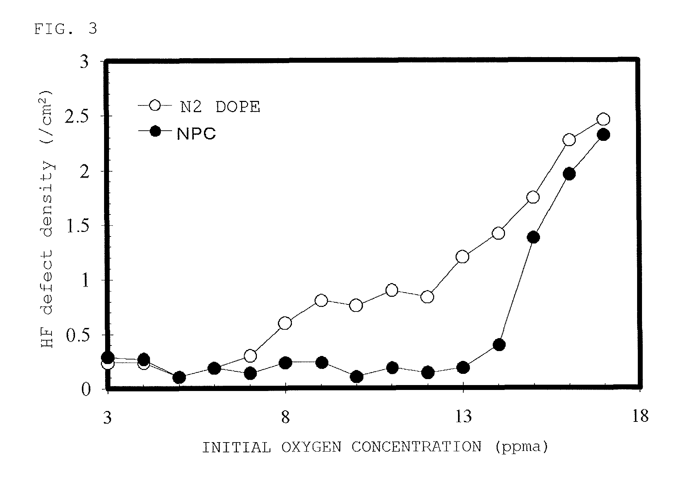

A heat treatment was performed at 1200°C under an oxygen atmosphere for 60 minutes on a wafer having a diameter of 200 mm, a nitrogen concentration of 5×10¹³ atoms/cm³, and an initial oxygen concentration of 3 to 17 ppma, and a N-region (NPC) wafer having a diameter of 200 mm, and an initial oxygen concentration of 3 to 17 ppma. The pseudo-reusing process was then repeated five times as in example 1 to measure the HF defect density. The result is shown in FIG. 3.

The result is that the HF defect density of both the wafers was at an acceptable level. Above all, HF defects were hardly detected for a nitrogen-doped wafer having an initial oxygen concentration of 7 ppma or less and an NPC wafer having an initial oxygen concentration of 14 ppma or less.

### (Example 3)

### Manufacture 1 of SOI Wafer

An N-region (NPC) mirror-polished silicon wafer having a diameter of 200 mm and an initial oxygen concentration of 12 ppma was prepared as a bond wafer. The bond wafer was heat treated at 1200°C under an oxygen atmosphere for 60 minutes to dissolve defects, and then etched with HF to remove an oxide film. The surface that would be the bonding interface was then polished by 0.1 µm. An SOI wafer was manufactured by the successive steps of: (i) forming an oxide film by an oxidation heat treatment at 900°C for 6 hours, (ii) implanting hydrogen ions through this oxide film under conditions of an acceleration energy of 70 keV and an implanting amount of 6×10¹⁶/cm², (iii) bonding the ions-implanted bond wafer to a base wafer (silicon wafer) at room temperature and separating the resultant wafer along the layer of the implanted ions by a separation heat treatment at 500°C for 30 minutes.

At that time, a separated wafer divided from the SOI wafer was produced. The steps (i) to (iii) were repeated with this separated wafer.

The measurement of the HF defects at the fifth reuse revealed that the result of the HF defects was at an acceptable level.

In addition, the obtained SOI wafer was free of faults such as defects in the SOI layer and high quality with excellent electrical properties.

### (Example 4)

### Manufacture 2 of SOI Wafer

An SOI wafer was manufactured as in example 3 except that a nitrogen-doped, mirror-polished silicon wafer having a diameter of 200 mm, a nitrogen concentration of 5×10¹³ atoms/cm³, and an initial oxygen concentration of 6 ppma was prepared as a bond wafer.

The measurement of the HF defects at the fifth reuse revealed that the result of the HF defects was at an acceptable level.

In addition, the obtained SOI wafer was free of faults such as defects in the SOI layer and high quality with excellent electrical properties.

It is to be noted that the present invention is not limited to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A method of manufacturing an SOI wafer, comprising the steps of:
preparing a silicon wafer as a bond wafer, the silicon wafer being sliced from a silicon single crystal ingot grown by a Czochralski method;
heat treating the prepared silicon wafer at a temperature ranging from 1100°C to 1250°C under an oxidizing atmosphere for 30 minutes to 120 minutes;
polishing a surface of the silicon wafer subjected to the heat treatment, the surface becoming a bonding interface;
forming an oxide film on the prepared silicon wafer after the heat treating step;
implanting ions into the silicon wafer on which the oxide film has been formed so as to form a layer of the implanted ions in the silicon wafer, the ions being implanted from the surface of the silicon wafer through the oxide film; and
bonding a base wafer to the silicon wafer in which the layer of the implanted ions has been formed and separating the silicon wafer along the layer of the implanted ions into a separated wafer and the SOI wafer.

2. The method of manufacturing an SOI wafer according to claim 1, wherein in the polishing step, after an oxide film formed on the silicon wafer by the heat treatment is removed, the surface is polished by 0.1 µm to 0.2 µm.

3. The method of manufacturing an SOI wafer according to claim 1 or claim 2, wherein the separated wafer is to be reused as the bond wafer when an SOI wafer is manufactured.

4. The method of manufacturing an SOI wafer according to any one of claims 1 to 3, wherein an N-region (Nearly Perfect Crystal) wafer having an initial oxygen concentration of 14 ppma or less, or a nitrogen-doped wafer having an initial oxygen concentration of 7 ppma or less is prepared as the silicon wafer.

5. The method of manufacturing an SOI wafer according to claim 4, wherein the nitrogen-doped wafer has a nitrogen concentration of 1×10¹³ to 1×10¹⁵ atoms/cm³.
